Europäisches Patentamt

European Patent Office

Office européen des brevets

(19)

(11) **EP 0 477 690 B1**

(12) **EUROPÄISCHE PATENTSCHRIFT**

(45) Veröffentlichungstag und Bekanntmachung des Hinweises auf die Patenterteilung:
**20.03.1996 Patentblatt 1996/12**

(51) Int Cl.$^6$: **H03M 7/36**, H03M 7/30, H03M 3/00, H03M 3/04

(21) Anmeldenummer: **91115491.2**

(22) Anmeldetag: **12.09.1991**

(54) **Verfahren zur Datenreduktion in der digitalen Verarbeitung einer Folge von Signalwerten**

Data reduction method for digital processing a series of signal values

Procédé pour la réduction de données dans le traitement numérique d'une suite de valeurs de signaux

(84) Benannte Vertragsstaaten:
**AT BE CH DE DK ES FR GB IT LI NL SE**

(30) Priorität: **27.09.1990 DE 4030620**

(43) Veröffentlichungstag der Anmeldung:
**01.04.1992 Patentblatt 1992/14**

(73) Patentinhaber: **SIEMENS AKTIENGESELLSCHAFT
D-80333 München (DE)**

(72) Erfinder: **Kerner, Horst
W-8000 München 60 (DE)**

(56) Entgegenhaltungen:
**US-A- 4 924 224**

- **DATENREDUZIERENDE BILDCODIE- RUNG,
1986, KURT RIEDEL, Francis Verlag, München**

**Beschreibung**

Die Erfindung bezieht sich auf ein Verfahren zur Datenreduktion in der digitalen Verarbeitung einer Folge von Signalwerten nach dem Oberbegriff des Anspruchs 1.

Aus der Literatur (Kurt Riedel: "Datenreduzierende Bildcodierung", Franzis' Verlag GmbH, München, 1986) ist ein Verfahren bekannt, mit dem eine Folge von Signalwerten, hier Grauwerte von Bildpunkten, datenreduzierend und reproduzierbar codiert werden kann. Das Verfahren beruht darauf, daß anstatt der Signalwerte die Differenzen zwischen aufeinanderfolgenden Signalwerten codiert werden. Nachdem ein erster Signalwert $x_1$ erfaßt ist, werden nur noch die Differenzen $D_i = x_i - x_{i-1}$, $i = 2, 3, ...$ ermittelt und codiert. Kann ein Signalwert L verschiedene Werte annehmen, so sind für die Differenzen 2L-1 Werte möglich. Eine Möglichkeit der Datenreduktion entsteht dadurch, daß die Signalwerte normalerweise stark korreliert sind und die Wahrscheinlichkeit des Auftretens großer Differenzen relativ gering ist. Zur Minimierung der mittleren Codewortlänge werden kleineren Differenzen, die eine höhere Auftrittswahrscheinlichkeit haben, kürzere Codeworte zugewiesen, große Differenzen mit geringerer Auftrittswahrscheinlichkeit erhalten längere Codeworte. Die Zuordnung der Codeworte zu den Signalwerten kann z. B. nach dem bekannten Huffman-Code erfolgen. Repräsentieren die Signalwerte statt der Grauwerte von Bildpunkten Abtastwerte einer analogen elektrischen Größe, wie sie z. B. in Uberwachungssystemen der Elektrizitätsversorgung gewonnen werden, so sind sie stärker korreliert, und das obengenannte Datenreduktionsverfahren führt noch nicht zu einem optimalen Ergebnis.

Der Erfindung liegt die Aufgabe zugrunde, das beschriebene Verfahren zur Datenreduktion so zu verbessern, daß sich für stark korrelierte Signalwerte eine Codierung mit einer weiter verringerten mittleren Codewortlänge ergibt.

Zur Lösung dieser Aufgabe weist das neue Verfahren der eingangs genannten Art die im kennzeichnenden Teil des Anspruchs 1 genannten Merkmale auf. Vorteilhaft kann das Verfahren gemäß Anspruch 2 zur Erfassung von Störvorgängen in der Elektrizitätsversorgung angewendet werden, da Signalwerte, die hier als Abtastwerte von Phasenströmen oder Spannungen gewonnen werden, sehr stark korreliert sind. Mit dem Merkmal des Anspruchs 3 ist eine weitere Datenreduktion durch die Codierung möglich.

Die Erfindung hat den Vorteil, daß sie für die Verarbeitung einer Folge von korrelierten Signalwerten eine weitere Datenreduktion erlaubt. Die mehrfachen Differenzenbildungen, deren optimale Zahl von der Korrelation der Signalwerte abhängt, wobei mit Korrelation ein irgendwie gearteter Zusammenhang der zeitlich aufeinanderfolgenden Signalwerte gemeint sein soll, können mit einem einfachen digitalen Filter vorgenommen werden. Mit gleichfalls geringem Aufwand ist die Rekonstruktion der Signalwerte aus den gebildeten Differenzen ohne Informationsverlust möglich. Besonders effizient ist das erfindungsgemäße Verfahren in Uberwachungssystemen der Elektrizitätsversorgung anwendbar, da die Abtastung von Phasenströmen oder -spannungen zu sehr stark korrelierten Signalwerten führt. Dabei werden Störungen, die dem sinusförmigen Verlauf eines Nutzsignals überlagert sind, verstärkt, während das Nutzsignal selbst durch die mehrfache Differenzenbildung kaum noch erscheint. Erfindungsgemäß kommen wenige Differenzwerte sehr häufig vor, so daß die bekannten Codierverfahren besonders vorteilhaft einsetzbar sind. Eine weitere Datenreduktion ist möglich, indem häufig auftretende Folgen von Differenzwerten mit einem Codezeichen codiert werden. Korrelationen von Signalwerten sind ebenso wie die Signalwerte selbst vom System abhängig, in dem die Signalwerte erzeugt werden. Eine einmal ermittelte Zahl der Differenzbildungen kann daher über einen längeren Zeitraum, für den das System als zeitinvariant angenommen wird, zu einer optimalen Datenreduktion führen.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen

Figur 1     ein System zur digitalen Signalverarbeitung,
Figur 2     ein digitales Filter zur Differenzbildung vierter Ordnung und
Figur 3     ein digitales Filter zur Rekonstruktion der Signalwerte.

In einem digitalen Signalverarbeitungssystem wird ein Signal x(t) vor der Abtastung durch ein Antialiasingfilter 1 bandbegrenzt. Die Abtastung erfolgt mit einem Abtasthalteglied 2 das von einem Taktgeber 3 mit der Abtastperiode T gesteuert wird. Das Antialiasingfilter 1 dient zur Ausfilterung der Frequenzanteile aus dem Signal x(t) die oberhalb der halben Abtastfrequenz liegen. Dem Abtasthalteglied 2 ist ein Analog-Digital-Umsetzer 4 nachgeschaltet, der Signalwerte $x_n$ ausgibt. Mit einem erfindungsgemäßen Differenzbildner 5 werden daraus Differenzen $D_n^{(k)}$ ermittelt, die ein Codewandler 6 zur Reduzierung der mittleren Codewortlänge umcodiert. Durch die Datenreduktion beanspruchen die so ermittelten Codeworte einen erheblich geringeren Speicherplatz in einem Speicher 7, als wenn die ursprünglichen Signalwerte $x_n$ abgespeichert würden. Zur Rekonstruktion der Signalwerte $x_n$ aus den abgespeicherten Codeworten sind dem Speicher 7 ein Codewandler 8 und ein digitales Filter 9 nachgeschaltet. Mit dem Codewandler 8 werden die Dif-

ferenzen $D_n^{(k)}$ zurückgewonnen, mit dem digitalen Filter 9 die Signalwerte $x_n$. Im gezeigten Ausführungsbeispiel führt das erfindungsgemäße Verfahren zu einer Verringerung des Speicherplatzbedarfs durch die Datenreduktion. Befände sich an der Stelle des Speichers 7 ein Übertragungskanal, so würde sich der Vorteil der Erfindung in einer Verkürzung der Datenübertragungszeit äußern.

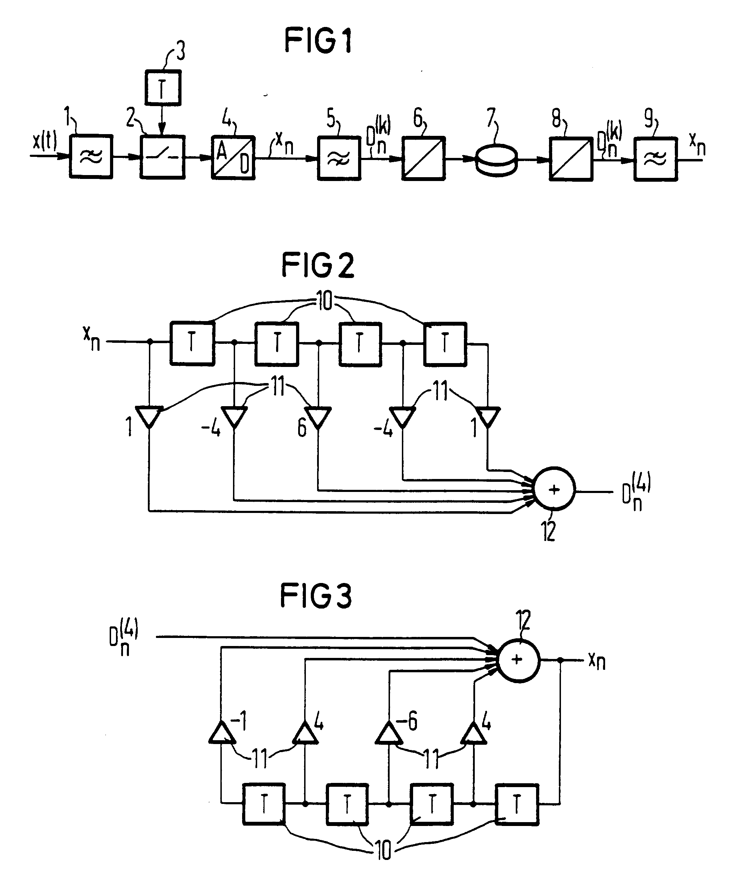

Der Differenzbildner 6 könnte z. B. als digitales Filter mit einem Netzwerk nach Figur 2 realisiert sein. Die Folge von Signalwerten $x_n$ wird dort durch hintereinandergeschaltete Verzögerungsglieder 10 jeweils um eine Abtastperiode T verzögert. Die Signalfolge $x_n$ sowie die daraus erzeugten verzögerten Signalfolgen werden in Multiplizierern 11 jeweils mit Faktoren 1, -4, 6, -4 und 1 multipliziert und in einem Addierer 12 zur Differenz $D_n^{(k)}$ vierter Ordnung aufsummiert.

Im folgenden soll kurz hergeleitet werden, daß das in Figur 2 dargestellte Netzwerk eines digitalen Filters einer vierfachen Differenzenbildung aus der Folge von Signalwerten $x_n$ entspricht.

Die erste Differenz wird mit den Gleichungen

$$D_1 = x_1 \tag{1.1}$$

$$D_i = x_i - x_{i-1}, \qquad i = 2, 3, \tag{1.2}$$

gebildet. Analog dazu kann die zweite Differenz mit den Gleichungen

$$D_1^{(2)} = D_1 \tag{2.1}$$

$$D_i^{(2)} = D_i - D_{i-1}, \qquad i = 2, 3, \tag{2.2}$$

ermittelt werden. Zur Bildung der k-ten Differenz müßte dieses Prinzip k-mal wiederholt werden. Es ist aber auch möglich, durch wiederholtes Einsetzen von Bestimmungsgleichungen vorhergehender Differenzen eine Gleichung für die k-te Differenz zu gewinnen, die außer der k-ten Differenz nur Signalwerte $x_i \ldots x_{i-k}$ enthält. Als Beispiel sollen hierzu nur die Gleichungen zur Ermittlung der zweiten Differenz ausführlich angegeben werden:

$$D_1^{(2)} = x_1 \tag{2.3}$$
$$D_2^{(2)} = x_2 - 2x_1 \tag{2.4}$$

$$D_i^{(2)} = x_i - 2x_{i-1} + x_{i-2}, \qquad i = 3, 4, \tag{2.5}$$

Durch wiederholtes Anwenden dieses Verfahrens kann die Gleichung

$$D_i^{(4)} = x_i - 4x_{i-1} + 6x_{i-2} - 4x_{i-3} + x_{i-4}, \qquad i = 5, 6, \tag{3.1}$$

welche das digitale Filter aus Figur 2 realisiert, ermittelt werden.

Zur Rekonstruktion der Signalwerte $x_i$ aus den Differenzen $D_i$ gibt es verschiedene Möglichkeiten. Eine ist die Summenbildung über die Differenzen $D_i$. Diese soll hier näher beschrieben werden. Die Signalwerte $x_i$ können aus den Differenzen $D_i$ gewonnen werden, indem nach der Formel

$$x_i = \sum_{m=1}^{i} D_m \tag{4.1}$$

die Differenzen $D_m$ bis zum i-ten Element aufsummiert werden. Da der Algorithmus zur Bildung der zweiten Differenz aus der ersten der gleiche ist, wie der zur Bildung der ersten Differenz aus den Signalwerten $x_i$, sind die ersten Differenzen $D_i$ aus den zweiten Differenzen $D_i^{(2)}$ durch eine Summenbildung nach der Formel

$$D_i = \sum_{m=1}^{i} D_m^{(2)} \tag{5.1}$$

auf analoge Weise ableitbar. Summiert man hier nach der Formel 4.1 die ersten Differenzen $D_i$ auf, so erhält man die Formel

$$x_i = \sum_{m=1}^{i} \left( \sum_{n=1}^{m} D_n^{(2)} \right), \qquad\qquad (5.2)$$

für die Rekonstruktion der Signalwerte $x_i$ aus den Differenzen zweiter Ordnung $D_i^{(2)}$. Die Rekonstruktion der Signalwerte $x_i$ aus den Differenzen $D_i^{(k)}$ k-ter Ordnung ist für größere k und i sehr aufwendig. Zur Gewinnung alleine des i-ten Signalwertes $x_i$ würde man näherungsweise $i^k/(k!)$ Additionen benötigen.

Eine sehr viel einfachere Möglichkeit zur Rekonstruktion der Signalwerte $x_i$ ist, die Differenzengleichung zur Bestimmung der i-ten Differenz $D_i^{(k)}$ nach $x_i$ aufzulösen. Z. B. wird dadurch aus der Gleichung 3.1 die Differenzengleichung

$$x_i = D_i^{(4)} + 4x_{i-1} - 6x_{i-2} + 4x_{i-3} - x_{i-4}, \qquad i = 5, 6, \qquad\qquad (6.1)$$

gewonnen. Das Netzwerk in Figur 3 realisiert diese Differenzengleichung. Signalwerte $x_n$ werden mit Hilfe eines Summierers 12 aus Differenzen $D_n^{(4)}$ durch Überlagerung mit verzögerten und jeweils mit Faktoren 4, -6, 4 und -1 gewichteten Signalwerten ermittelt. Der Aufwand zur Rekonstruktion reduziert sich damit auf vier Verzögerungsglieder 10, vier Multiplizierer 11 und einen Summierer 12 mit fünf Eingängen. Das Netzwerk aus Figur 3 repräsentiert also ein digitales Filter, welches durch ein Programm für eine Rechenanlage oder durch eine fest verdrahtete Schaltung realisiert werden kann.

**Patentansprüche**

1. Verfahren zur Datenreduktion in der digitalen Verarbeitung einer Folge von Signalwerten ($x_n$), wobei

   - in einem ersten Schritt Differenzen $D_i$ aufeinanderfolgender Signalwerte $x_{i-1}$ und $x_i$ gebildet werden,

   **dadurch gekennzeichnet,**

   - daß in k weiteren Schritten jeweils Differenzen $D_i^{(j+1)}$, mit j = 1 ... k - Nummer des weiteren Schritts, aus aufeinanderfolgenden Differenzen $D_{i-1}^{(j)}$ und $D_i^{(j)}$ des jeweils vorhergehenden Schritts gebildet werden,
   - daß die im letzten weiteren Schritt gebildeten Differenzen $D_i^{(k+1)}$ derart codiert werden, daß denjenigen mit höherer Auftrittswahrscheinlichkeit kürzere Codeworte zugewiesen werden als denjenigen mit geringerer Auftrittswahrscheinlichkeit, und
   - daß die Anzahl k der weiteren Schritte eine so gewählte natürliche Zahl ist, daß sich für die Codierung der Differenzen $D_i^{(k+1)}$ ein Minimum der mittleren Codewortlänge ergibt.

2. Verfahren nach Anspruch 1, **dadurch gekennzeichnet**, daß

   - die Folge von Signalwerten ($x_n$) Abtastwerte von Phasenströmen oder -spannungen zur Erfassung von Störvorgängen in der Elektrizitätsversorgung sind.

3. Verfahren nach Anspruch 1 oder 2, **dadurch gekennzeichnet**, daß

   - häufig auftretende Kombinationen der Differenzen $D_i^{(k+1)}$ mit einem Codezeichen codiert werden.

**Claims**

1. Method for data reduction in the digital processing of a series of signal values ($x_n$), wherein

- in a first step differences $D_i$ of consecutive signal values $x_{i-1}$ and $x_i$ are formed, characterised in that
- in k further steps respective differences $D_i^{(j+1)}$ with $j = 1 \ldots k$ - number of the further step, are formed from consecutive differences $D_{i-1}^{(j)}$ and $D_i^{(j)}$ of the respective previous step,
- the differences $D_i^{(k+1)}$, which are formed in the last further step, are coded in such a way that those having a higher probability of occurring are allocated shorter codewords than those having a lower probability of occurring, and
- the number k of further steps is a natural number which is chosen in such a way that a minimum average codeword length is produced for the coding of the differences $D_i^{(k+1)}$.

2. Method according to claim 1, characterised in that

- the series of signal values $(x_n)$ are (sic) sampled values of phase currents or phase voltages for detecting interference phenomena in the supply of electricity.

3. Method according to claim 1 or 2, characterised in that

- frequently occurring combinations of differences $D_i^{(k+1)}$ are coded with a code character.

**Revendications**

1. Procédé de réduction de données lors du traitement numérique d'une suite de valeurs $(x_n)$ d'un signal,

- dans lequel on forme, au cours d'une première étape, des différences $D_i$ de valeurs successives $x_{i-1}$ et $x_i$ de signal,

caractérisé en ce que

- on forme, lors de k étapes supplémentaires, des différences $D_i^{(j+1)}$ entre des différences $D_{i-1}^{(j)}$ et $D_i^{(j)}$ successives de l'étape précédente, où $j = 1 \ldots k$ est le numéro de l'étape supplémentaire,
- on code les différences $D_i^{(k+1)}$ formées dans la dernière étape supplémentaire, de telle sorte qu'il soit associé à celles des différences, qui ont une probabilité d'apparition plus grande, des mots de code plus courts qu'à celles, qui ont une probabilité d'apparition plus petite, et
- le nombre k des étapes supplémentaires est un entier naturel choisi de sorte à obtenir pour le codage des différences $D_i^{(k+1)}$ un minimum de la longueur moyenne des mots de code.

2. Procédé suivant la revendication 1, caractérisé en ce que

- les suites des valeurs $(x_n)$ du signal sont des valeurs d'échantillonage de courants ou de tensions de phases destinées à détecter des phénomènes parasites dans l'alimentation en électricité.

3. Procédé suivant la revendication 1 ou 2, caractérisé en ce que

- on code des combinaisons apparaissant fréquemment des différences $D_i^{(k+1)}$ par un signe de code.

# FIG 1

# FIG 2

# FIG 3